# EUROPEAN PATENT SPECIFICATION

(11) **EP 1 820 235 B1**
(45) Date of publication and mention of the grant of the patent: **23.07.2008**
(21) Application number: 04809026.0
(22) Date of filing: 01.12.2004
(51) Int. Cl.: H01P 3/08, H05K 1/14, H01R 9/00

(54) **A STRIPLINE ARRANGEMENT AND A METHOD FOR PRODUCTION THEREOF**
STREIFENLEITUNGSANORDNUNG UND VERFAHREN ZU IHRER HERSTELLUNG
LIGNE MICRORUBAN ET PROCEDE DE PRODUCTION

(43) Date of publication of application: 22.08.2007
(73) Proprietor: Telefonaktiebolaget LM Ericsson (publ), 164 83 Stockholm (SE)
(72) Inventor: RIVAS, Patrik, S-441 60 Alingsås (SE); BERNDTSSON, Andreas, S-417 04 Göteborg (SE)
(74) Representative: Vejgaard, Christian
(86) International application number: PCT/SE2004/001807
(87) International publication number: WO 2006/059934

(56) References cited:
- EP-A2- 0 162 474
- WO-A-86/03891
- US-A1- 2002 171 516
- PATENT ABSTRACTS OF JAPAN vol. 007, no. 162 15 July 1983 & JP 58 070 601 A (MITSUBISHI DENKI KK) 27 April 1983

## Description

### FIELD OF THE INVENTION

The present invention relates to a stripline arrangement comprising a number of stripline layers each comprising a laminate layer and conducting layers provided thereon. At least some of the conducting layers comprise a respective conductive pattern and the arrangement further comprises RF/microwave signal input and output ports and at least two of said stripline layers are arranged such that a given overlapping zone is provided between each other facing conducting layers of said stripline layers.

The invention also relates to a method for producing a stripline arrangement comprising a number of stripline layers, each of which comprises a laminate layer and conducting layers.

### STATE OF THE ART

Stripline arrangements are well known in the art. However, it has always been a problem with the connections of stripline assemblies, e.g. inputs/outputs for example to components and modules having various functionalities. So far a so called 1-way connection has been used. A 1-way connection is a solution in which all connecting means or connectors are located in one and the same plane. This makes connection to, or integration with, other components complicated and un-necessarily space demanding and it is particularly difficult when it would be desirable to implement for example a so called tile technique which is a vertical building technique in which components or modules etc. are mounted vertically or on top of each other. Hence, so far there has been no satisfactory solution as far as the connections of stripline arrangements are concerned and so far it has e.g. been substantially impossible to design tile products or PCB boards (Printed Circuit Boards) requiring connections on both sides of the boards using the stripline technique.

JP 58070601 shows a triplate line microwave circuit comprising stripline layers, each comprising a laminate layer and conducting layers with input and output terminals and with overlapped outer conductors for simplified manufacture and improved reliability. However, the electrical performance is not as good as would be desired and the arrangement is not controllable. Moreover it may involve high losses.

### SUMMARY OF THE INVENTION

What is needed is therefore an improved stripline arrangement as initially referred to which is easy to design and fabricate. Still further an improved stripline arrangement for providing a 2-way connection possibility is needed. Still further an improved arrangement is needed for which it is possible to provide connectors in different planes, particularly on both sides of a stripline arrangement comprising a stripline board, or PCB board. Still further a stripline arrangement is needed which has low losses, or a low reflection, and which is broad-banded. Particularly a stripline arrangement is needed which has a good controllability. Even more particularly a stripline arrangement is needed which is flexible and which can be used in for example so called tile products or similar compact connection assemblies. Further yet, a stripline arrangement is needed which allows for easy and flexible arranging of functional entities or components in layers on each other. Even more particularly a stripline arrangement is needed which is compact and can be used in or with various components and in which a conductive pattern, particularly a distribution network, easily can be provided not only in a cheap manner but also in a very compact and extremely flexible manner.

Therefore a stripline arrangement as initially referred to is provided which comprises an interconnecting arrangement for interconnecting said stripline layers comprising a bonding arrangement provided between adjacent and one another facing and overlapping conducting layers (arranged on different laminate layers). Further, connectors are provided substantially perpendicularly with respect to the extension plane of the respective stripline layer and they cross said laminate layer and its conducting layers for, in said overlapping zone, providing contact between adjacent conducting layers of adjacent stripline layers. The laminate layers comprise dielectric, ferroelectric layers. The dimension of the overlapping zone in the plane of the interconnected stripline layers comprises approximately λ/4, wherein λ is the wavelength corresponding to the mid-frequency of handled RF waves or microwaves.

Particularly said laminate layers comprise dielectric layers with a given dielectric constant. The dielectric constant may vary between for example 2 and 200 depending on implementation or application and it is frequency dependent, i.e. it depends on the frequency of input RF signals or microwave signals and it has hence to be adapted, i.e. a material has to be selected which is adecuate for the specific implementation. Particularly it is selected with regard to the signal mid-frequency in order to reduce losses, or reflections, and in order to provide a broadband arrangement with a particularly good controllability. In a particular embodiment the laminate layers comprise ferroelectric layers. One example on a laminate is Rogers 3003™ with a dielectric constant of about 3.

The conducting layers particularly comprise a metal, such as for example Cu, Ag or Au in a conventional manner. The bonding layer may for example comprise a so called prepreg material such as for example ARLON 6250 (TM). The bonding film is particularly matched to the dielectric, or the laminate layers in general, the thinner the board or stripline arrangement, the larger ε has to be selected (i.e. the laminate material) since the wavelength is inversely proportional to the square root of the dielectric constant, (λ_{g} = c/f x √εr), λ_{g} being the wavelength in the conductor, f the mid-frequency of the frequency band and εᵣ being the relative dielectric constant.

In an alternative embodiment the bonding arrangement may comprise screws or similar connecting means which substantially are mechanically operative.

Particularly the bonding film, if such is used, between two conducting layers comprises recesses or similar, for example cut-outs, adjacent to or in association with the connectors, such that said recesses or similar at least are provided where connectors protrude from a conducting layer of a stripline layer in order to prevent contact with the conducting layer of the adjacent stripline layer. Most advantageously the connectors are so called connector pins taken up in through holes in the respective stripline layers. Particularly the "head" of the connector pin is soldered onto the conducting layer of the respective stripline layer in which it is taken up.

Most particularly each laminate layer is sandwiched between a first and a second conducting layer.

In an advantageous implementation said input and/or output ports are formed by one or more of said connectors providing vertical input/output ports arranged in different layers (i.e. vertical on condition that the extension plane of the stripline is defined as horizontal, in more general terms perpendicular to said plane of extension). However, the inventive concept according to which an overlap is provided in order to connect stripline layers is not exclusively limited to vertically input/output ports in different layers but may also be implemented with input/output ports in one and the same plane or for example one might be parallel with the planar extension of the stripline arrangement whereas the other is vertically disposed etc. Any variation is in principle possible, but a particularly advantageous embodiment is provided through arranging the connectors on both sides of a stripline arrangement or a PCB (Printed Circuit Board).

Particularly the conducting films comprise recesses, cut-outs or similar, allowing the connectors to protrude substantially perpendicularly with respect to the extension plane of the stripline layers, in order to form said input and/or output ports, from the laminate layer without contacting the conducting layer, i.e. the respective external conducting layer located opposite to the respective conducting layers facing each other at the interconnection. Particularly the respective protruding portions of the connectors forming input/output ports are taken up in a respective connector housing.

In specific embodiments a plurality of stripline layers are interconnected substantially perpendicularly to their planar extension via said connectors with modules or elements, e.g. forming a tile or brick like connection assembly. Thus, particularly the arrangement comprises a so called 2-way stripline assembly with perpendicularly to the plane of extension, e.g. vertically, disposed contacts or connectors, such that the connectors are disposed in different planes, or on both or opposite sides of e.g. stripline or PCB boards.

In one particular embodiment the connectors comprise so called GPO (Gilbert Push On) connectors, each comprising a connector pin and a connector housing. The connector pin is mounted in the laminate layer, or a PCB, whereas the connector housing is soldered or similarly onto a ground plane disposed on the external corresponding conducting layer disposed on the laminate layer of the respective stripline layer.

Particularly the overlapping conducting layers (or one of the conducting layers) comprises a distribution network, e.g. for power distribution to a plurality of radiating elements in an antenna system. Of course the distribution network can be used for any other application as well and the conductive pattern may particularly be provided in both or in one of the overlapping conducting layers. The other conducting layer (of the same stripline layer, i.e. disposed on the opposite side of the respective laminate layer) may also simply be used to establish a connection with a conducting layer of the interconnected stripline layer. Such a conducting layer may be formed by removal of up to 98-99% of all the conducting material of the conducting layer thus leaving only the required connections. Of course also other implementations are possible.

The stripline arrangement particularly comprises a stripline board with two laminate layers. It may also comprise a plurality of stripline layers with conducting layers disposed on either sides of respective laminate layers, wherein at least two adjacent stripline layers (other than those interconnected according to the inventive concept) are interconnected by means of vias, i.e. forming a multilayer structure.

The invention also discloses a method for producing a stripline arrangement comprising a number of stripline layers, each of which comprising a laminate layer disposed between conducting layers. The method comprises the steps of; etching conductive patterns in respective conducting layers disposed on either sides of a dielectric or ferroelectric laminate layer for at least two such stripline layers; arranging, e.g. soldering, connector means onto a respective first respective conducting layer disposed on each of the laminate layers, such that said connector means extend through said laminate layers substantially perpendicularly to the planar extension thereof such as to protrude through a respective second conducting layer disposed on the opposite side of said respective laminate layer; mounting said at least two stripline layers substantially parallelly onto each other such that an overlap is formed between the adjacent, each other facing, conducting layers of said stripline layers, whereby said overlap includes a number of connectors, and selecting the dimension of said overlap in a direction substantially parallel to the planar extension of said stripline layers in dependence of the wavelength of RF waves or microwaves to be handled by the stripline arrangement the dimension of the overlap comprising a quarter wavelength of said wavelength.

This can be done in one or more steps but generally no more than three steps comprising heating up in an oven as is known in the art. The hole stripline arrangement may also be formed in one single step. The respective conductive patterns are generally different and only in one conductive layer a so called distribution network is provided, or more particularly in both adjacent conducting layers in the overlap zone, the other layers solely having the function of providing interconnection and connection with externally mounted components. Particularly the method further comprises the step of; using said connectors as input/output ports, said input/output ports hence being located in different planes, on opposite sides of the stripline arrangement. The method further comprises the step of removing conducting material around the protruding portions or around the portions where connector parts protrude, which connector parts are to act as input/output ports; arranging housings to externally surround said as inputs/outputs intended connector parts.

The method further particularly comprises the step of; soldering said housings onto ground planes provided externally of said respective conducting layers with respect to the laminate layers to which they are connected.

The method preferably comprises the step of; bonding, by means of a bonding layer, two conducting layers of said at least two stripline layers to each other such that, in the conducting layer overlapping area, recesses or cut-outs are provided substantially around said, perpendicularly to the extension plane of the transmission line arrangement extending, connectors protruding from the stripline arrangement. The connectors particularly comprises connector pins.

The method advantageously further comprises the step of; connecting a number of modules by means of said connectors, i.e. the protruding parts thereof, such that a perpendicular, particularly vertical contact connection assembly is formed. Such may for example be used to connect a plurality of antenna elements in antenna system implementations. Of course also other implementations are possible.

### BRIEF DESCRIPTION OF THE DRAWINGS

The invention will in the following be further described, in a non-limiting manner, and with reference to the accompanying drawings, in which:
- Fig. 1: is a very schematical cross-sectional view of a stripline arrangement according to the invention,
- Fig. 2: is a more detailed view of one embodiment of a stripline arrangement according to the invention,
- Fig. 3: shows an example of an application of a stripline arrangement according to the invention with vertical (perpendicular) contacts in different planes and to which a number of modules are connected,
- Fig. 4: is a diagram illustrating simulated results for connectors in an optimization tool to a specific frequency band, and
- Fig. 5: is a flow diagram describing one method for manufacturing a stripline arrangement according to the present invention.

### DETAILED DESCRIPTION OF THE INVENTION

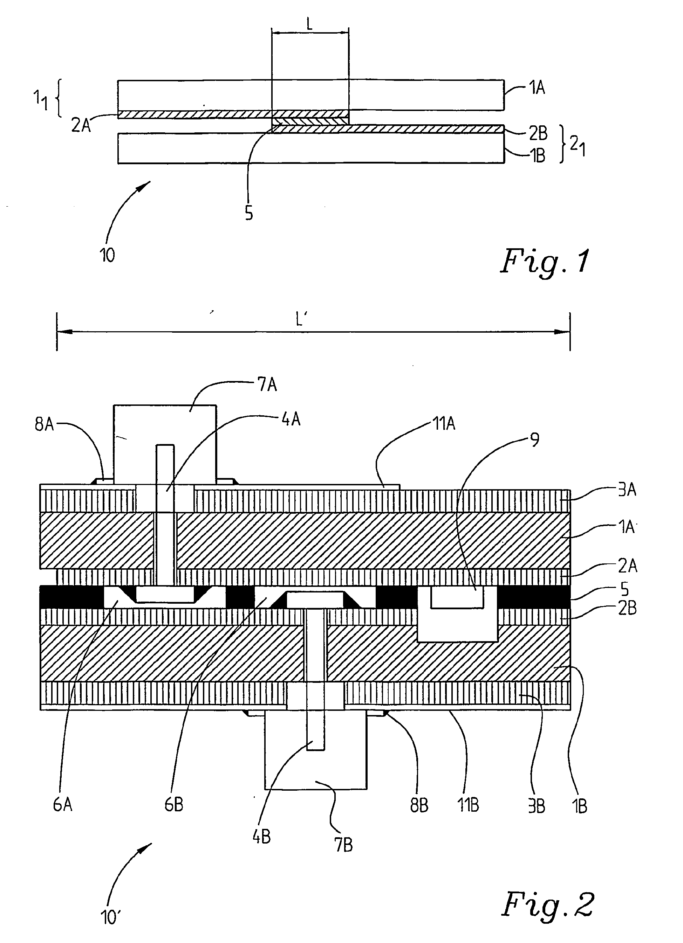

Fig. 1 very schematically illustrates, in cross-section, a stripline arrangement 10 according to the present invention. The arrangement 10 comprises a first stripline layer 1₁ comprising a laminate layer 1A with a conducting layer 2A and a second stripline layer 2₁ comprising a laminate layer 1B with a conducting layer 2B. It is supposed that the stripline layers comprise laminate layers 1A, 1B which comprise a dielectrical or ferroelectrical material such as for example Rogers 3003. Of course the invention is not limited to use of this specific material but any appropriate material can be selected, and the material has to be selected such that the dielectric constant is appropriate for the desired implementation. The wavelength of an input RF signal or a microwave signal in the stripline arrangement λ_{g} depends on the dielectric constant as λ_{g} = c/f x √εᵣ, and if a particularly thin board is desired, a material with a higher dielectric constant has to be selected and vice versa. The stripline layers 1₁, 2₁ are so disposed that an overlapping zone or an overlap with length L is formed between the each other facing conducting layers 2A, 2B, and a bonding arrangement 5, for example a bonding film, is disposed for connecting the conducting layers 2A, 2B to one another. In particular the bonding film 5 is selected such as to match the dielectricum, i.e. the dielectric constant of the laminate layers 1A, 1B. The dimension L of the overlapping zone in a direction in the planar extension of the stripline arrangement 10, is selected depending on the wavelength of the RF/microwave signal relevant for the concerned application. The overlapping dimension L is particularly dependent on the frequency of the RF/microwave signal and, most advantageously, it should be substantially λ/4 of the RF/microwave signal in order to provide for a good electrical performance. It is particularly ¼ of the wavelength of the mid-frequency of the relevant RF/microwave signal in order to reduce losses or reflections and in order to assure that a particularly broad-banded arrangement is provided which additionally shows a very good controllability.

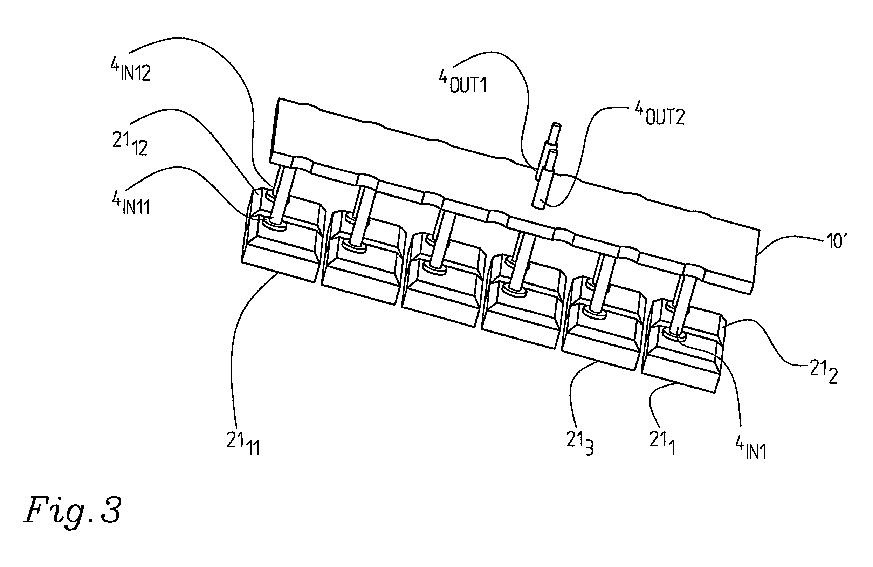

Particularly the thickness of the stripline arrangement 10 is of the magnitude 3 mm. However, the figure 3 mm is merely given as an example to illustrate that it is a comparatively thin arrangement; it may also be even thinner than that, e.g. 1.5 mm (or thicker). The given figures are merely to be seen as examples.

Depending on implementation or intended application the laminate material is selected to have a dielectric constant between for example 2 and 200 or lower or higher as well.
In the embodiment of Fig. 1 no input/output ports are illustrated and hence it should be clear that the input ports may be disposed perpendicularly as well as horisontally with respect to the planar extension of the stripline arrangement. A particularly advantageous embodiment relates to the case when the contacts or input/output ports are disposed substantially orthogonally with respect to the planar extension of the stripline arrangement and on opposite sides thereof as will be more thoroughly discussed with reference to for example Fig. 2. In addition to the connecting arrangement, connectors, particularly connector pins are provided in the overlapping zone (cf. Fig. 2) and the overlap is particularly indispensible in order to enable the use of, particularly in different planes, disposed input/output ports. It should also be clear that the bonding arrangement does not necessarily have to be a bonding film or a glue film, but also mechanically bonding or connection means could be used (not shown).

Fig 2 shows an advantageous implementation of the invention comprising a stripline arrangement 10' or a PCB with vertical connections in two planes, i.e. a 2-way stripline arrangement, (particularly applicable for all frequencies depending on selected dielectric constant) where the connections or input/output ports are disposed on both sides of the stripline arrangement 10'. Similar reference numerals are used for similar components as compared to Fig. 1. Thus, a first stripline layer comprises a laminate layer 1A with a first conducting layer 2A disposed on one side and a second conducting layer 3A disposed on the other side of said laminate layer 1A which is connected to a second stripline layer comprising a second laminate layer 1B with a first conducting layer 2B disposed on one side thereof and a second conducting layer 3B disposed on the other side of said laminate layer 1B. A bonding arrangement 5 comprising a bonding film is provided in the overlapping zone having an extension L'. A first perpendicular (vertical) connector 4A is further taken up in a through hole in the first laminate layer 1A and the respective conducting layers 2A, 3A connected to said first laminate layer 1A. Said connector 4A particularly comprises a connector pin with a "head", and said "head" of said connector pin 4A is particularly soldered onto the first conducting layer 2A disposed on said first laminate layer 1A, hence protruding through the second conducting layer 3A.

Particularly recesses may be provided in portions of the bonding film surrounding the soldered connector heads to prevent their contacting the conducting layer 2B of the second laminate layer 1B and vice versa. In a similar manner a second connector 4B, particularly a connector pin, is soldered onto the first conducting layer 2B disposed on the second laminate layer 1B. Around the solder 6B a recess or similar may be provided as discussed with reference to the first connector 4A.

A portion of the second conducting layer 3A is removed, or there is no conducting material, in an area surrounding the external protrusion of the first connector 4A to prevent conducting connection between the connector 4A and the second conducting layer 3A to provide an output port (of course it may also be an input port, but in this implementation it is supposed that it acts as an input port) and a housing or connector house 7A is soldered, indicated through solder 8A, onto a ground plane 11A provided on the conducting layer 3A. Similarly a recess or similar is provided in the second conducting layer 3B disposed on the second laminate layer 2B where the connector 4B protrudes externally and a housing 7B is soldered (solder 8B) onto a ground plane 11B provided on the second conducting layer 3B disposed on the second laminate layer 1B. The connector, or particularly the connector pin, 4B in this case acts as an input port, although, it of course also may be operative as an output port depending on implementation.

In Fig 3 below it is schematically illustrated an implementation of a stripline arrangement as in Fig. 2 comprising two output/input ports and 12 input/output ports provided through connector pins 4A, i.e. on top of Fig. 2. Onto the ports 4ᵢₙ₁,..., 4ᵢₙ₁₂ modules 21₁,...,21₁₂ can easily be mounted, e.g. snapped on directly or indirectly via intermediate means. In figure 2 it is also illustrated a chip-resistor 9 connected to the first conducting layer 2A in a conventional manner, which however is not specific for the present invention and therefor will not be more thoroughly described herein. Particularly the conducting layer 2A disposed on the first laminate layer 1A comprises a distribution network, together with layer 2B in the overlapping zone, etched in the conducting material in such as to leave only the conductive pattern. The conductive patterns in the other conducting layers are particularly provided in order to provide connection between the layers and input/output sides.

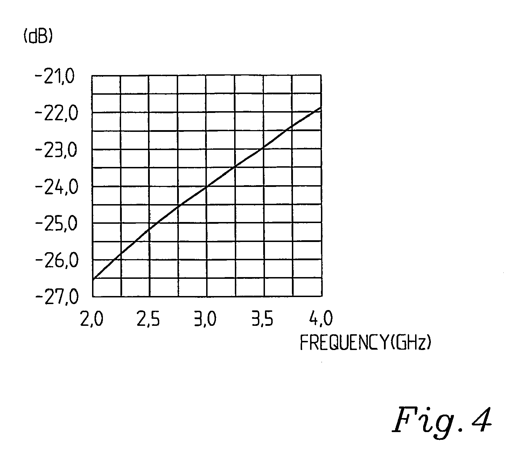

As referred to with reference to Fig. 2, the overlap L' particularly comprises λ/4. The connectors 4A, 4B, particularly connector pins, may for example comprise so called GPO (Gilbert Push On) connectors which are perpendicularly (vertically) disposed with respect to the stripline arrangement, or the PCB. Such a connector solution particularly consists, as can be seen from figure 2, of a connector house 7A, 7B and a connector pin 4A, 4B. The connector pins 4A, 4B are amounted onto the PCB or stripline arrangement, whereas the connector houses 7A, 7B are soldered onto the respective ground planes as discussed above. Due to the connector pins 4A, 4B, reflections are produced; therefore the connectors have to be optimized for respective application specific frequency bands. This may for example be done in simulation tools, one example thereof being HP HFSS (Ansoft ver. 8.5™) and in Fig. 4 some simulation results for connectors are illustrated as the suppression in dB versus frequency (in GHz).

It should be clear that this merely constitutes one particular example; optimization may of course also be provided for in a number of other ways.

The inventive concept may be used in many different applications, one thereof being in antenna systems in which the modules (see Fig. 4) 21₁, 21₂ ,..., 21₁₂ are mounted at contacts of the (here) 12 input/output ports. Said modules may then be connected to respective antenna elements or radiating elements which is very advantageous.

Since the output ports or the input ports are oppositely directed in relation to for example antenna ports (not shown) the stripline transmission needs to change from one stripline layer to another and in a particular embodiment all hybrides and transmission lines are provided on one of the stripline layers, i.e. the conducting layer disposed thereon, but at a given distance before for example an input port, the transmission line needs to change to the other e.g. lower stripline layer and this is taken care of through the overlapping zone as discussed above.

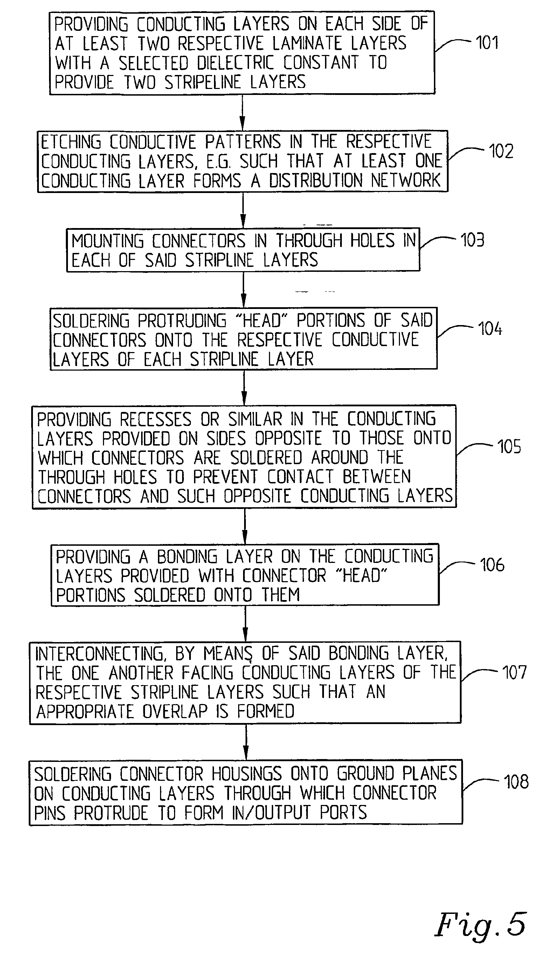

Fig. 5 schematically illustrates one example of a manufacturing method for producing a stripline arrangement according to the present invention. According to the embodiment described with reference to flow diagram of Fig. 5, a stripline arrangement with a number of modules connected thereto may be produced as follows: In a first step, conducting layers are provided on each side of at least two respective laminate layers with a selected dielectric constant to form at least two, here called, stripline layers, 101. Subsequently respective conductive patterns are etched in the respective conducting layers, of which at least one (on one of the stripline layers or adjacent conducting layers in the overlap zone) for example is a distribution network, 102. It should be clear that the conductive patterns may take many forms depending on implementation. Subsequently connectors are mounted in through holes provided in each of said stripline layers, 103. The invention is not limited to any specific way of providing such through holes, or using any specific mounting technique or similar. Subsequently enlarged or broadened protruding portions of said connectors, e.g. connector heads or similar, are soldered onto one of the respective conducting layers of the respective stripline layers, 104, such that the connector or connector pins are soldered onto one of the conducting layers disposed on a laminate layer and protrudes through the other conducting layer on the opposite side of said same stripline layer, 104. At this stage, or at an earlier stage, recesses or similar are provided in the conducting layers located on those sides of the laminate layers which are opposite to the solders around the connectors, which recesses or similar substantially surround through holes to prevent contact between the respective connectors and the conducting layers on those sides which are opposite to the solders, 105. Then a bonding layer is provided on the conducting layers on the sides of the stripline layers where the connectors are soldered, 106. The at least two stripline layers are then interconnected through interconnection of the conducting layers onto which a connector is soldered, respectively, by means of a bonding layer or similar, such that an overlap is formed between the adjacent respective conducting layers of the respective stripline layers, 107. The size of the overlap etc. has been discussed earlier in the application and will therefore not be further described here. Finally, connector houses are soldered onto ground planes disposed on the layers forming external conducting layers surrounding protruding connector pins, hence providing forming input/output ports through said protruding connectors with housings mounted thereon, 108. Finally, modules may simply be mounted onto said connectors or connector housings, which modules in turn may be mounted onto for example antenna elements or similar.

It should be clear that these steps can be performed in different orders, the boards may be joined in different steps etc. However, generally the stripline layers etc. do no withstand being heated up more than three times, hence the assembling procedure should preferably be performed in one, two or three steps.

It should also be clear that the invention of course not is limited to the specifically illustrated embodiments but that it can be varied in a number of ways within the scope of the appended claims and that it can be used for several different applications, not only for antenna systems but also in other applications, particularly if a distribution network is needed for distributing signals to microwave products (millimeter wave products), or such products, and where it is appropriate to have vertical, or more generally perpendicular, in relation to the stripline arrangement, provided contacts, which offers a very cheap and easy way to manufacture assemblies which for example may be built up in the form of tile or brick-like structures and where compact solutions are needed.

## Claims

1. A stripline arrangement (10;10') comprising a number of stripline layers (1₁, 2₁) each comprising a laminate layer (1A, 1B) and conducting layers (2A, 2B; 2A, 2B, 3A, 3B) provided on each of said laminate layers, said conducting layers each comprising a conductive pattern, RF signal input and output ports respectively, at least two of said stripline layers being arranged such that a given overlapping zone (L;L') is provided between each other facing conducting layers (2A, 2B) of said striplines layers,
an interconnecting arrangement (5) for interconnecting said striplines layers (1₁, 2₁) comprising a bonding arrangement (5) is provided between adjacent and one another facing and overlapping conducting layers (2A, 2B), connectors (4A, 4B) are provided substantially perpendicularly with respect to an extension plane of the respective stripline layers and crossing said laminate layers (1A, 1B), **characterized by** comprising dielectric, ferroelectric layers and conducting layers (2A, 2B, 3A, 3B), said interconnecting arrangement, in said overlapping zone (L;L'), providing contact between the adjacent conducting layers (2A, 2B) of adjacent stripline layers (1₁, 2₁), and in that the dimension of the overlapping zone (L; L') in the plane of the interconnected stripline layers comprises approximately λ/4, λ being the wavelength corresponding to the mid-frequency of the RF waves handled by the arrangement.

2. A stripline arrangement according to claim 1,
**characterized in**
**that** the conducting layers (2A, 2B, 3A, 3B) comprise a metal, e.g. Cu, Ag or Au.

3. A stripline arrangement according to any one of claims 1 or 2,
**characterized in**
**that** the bonding arrangement (5) comprises a bonding film.

4. A stripline arrangement according to any one of claims 1-3,
**characterized in**
**that** the bonding arrangement comprises screws or similar mechanically operative connecting means.

5. A stripline arrangement according to claim 3,
**characterized in**
**that** the bonding film (5) between two conducting layers (2A, 2B) is disposed such as to provide recesses (6A, 6B) or similar adjacent to or in association with the connectors (4A, 4B), such that said recesses or similar at least are provided where the connectors (4A, 4B) protrude from a conducting layer (2A, 2B) of a stripline layer to prevent contact with the conducting layer (2B, 2A) of the adjacent stripline layer.

6. A stripline arrangement according to any one of claims 1-5,
**characterized in**
**that** the connectors (4A, 4B) comprise connector pins taken up in through holes in a respective stripline layer.

7. A stripline arrangement according to any one of the preceding claims,
**characterized in**
**that** each laminate layer (1A, 2A) is sandwiched between a first (2A, 2B) and a second (3A, 3B) conducting layer.

8. A stripline arrangement according to claim 7,
**characterized in**
**that** said input and/or output ports are formed by one or more of said connectors (4A, 4B).

9. A stripline arrangement according to claim 8,
**characterized in**
**that** the conducting layers (3A, 3B) comprise recesses, cut-outs or similar allowing the connectors (4A, 4B) to protrude perpendicularly with respect to the extension plane of the stripline layers to form said input and/or output ports without contacting the respective conducting layers (3A, 3B) through which said connectors (4A, 4B) protrude.

10. A stripline arrangement according to claim 9,
**characterized in**
**that** the protruding portions of the connectors (4A, 4B) forming input/output ports are taken up in respective housings (7A, 7B).

11. A stripline arrangement according to any one of the preceding claims,
**characterized in**
**that** a plurality of stripline layers are interconnected substantially perpendicularly to their planar extension via connecting arrangements with modules or elements forming a tile or brick-like connection assembly.

12. A stripline arrangement according to any one of claims 1-11,
**characterized in**
**that** it comprises a 2-way stripline assembly with, perpendicularly to the plane of extension, e.g. vertically, disposed contacts or connectors such that the connectors are disposed in different planes, or on both or opposite sides of the stripline assembly.

13. A stripline arrangement according to any one of the preceding claims,
**characterized in**
**that** the connectors comprise GPO, i.e. Gilbert Push On, connectors, each with a connector pin (4A, 4B) and a connector housing (7A, 7B), the connector pin being mounted in the laminate layer, or a PCB, and the connector housing being soldered or similarly to a ground plane disposed on the corresponding conducting layer.

14. A stripline arrangement according to any one of the preceding claims,
**characterized in**
**that** the dielectric constant (εᵣ) of the laminate layers is selected depending on wavelength and application of handled RF/microwaves, and has a value of 2-200.

15. A stripline arrangement according to any one of the preceding claims,
**characterized in**
**that** it comprises a distribution network for power distribution to a plurality of radiating elements in an antenna system, said distribution network being provided by the conducting layers (2A, 2B) in the overlapping zone.

16. A stripline arrangement according to any one of the preceding claims,
**characterized in**
**that** it comprises a stripline board with two laminate layers (1B, 2B).

17. A stripline arrangement according to any one of claims 1-15,
**characterized in**
**that** it comprises a plurality of stripline layers with conducting layers disposed on either sides of respective laminate layers wherein at least two adjacent stripline layers are interconnected by means of vias, hence forming a multilayer structure.

18. A method for producing a stripline arrangement comprising a number of stripline layers each of which comprising a laminate layer disposed between conducting layers,
**characterized in**
**that** it comprises the steps of:
- etching conductive patterns in respective conducting layers disposed on either sides of a dielectric or ferroelectric laminate layer for at least two such stripline layers;
- arranging connector means onto a respective first conducting layer disposed on each of said laminate layers, such that said connector means extend through said laminate layers substantially perpendicularly to the planar extension thereof such as to protrude through a respective second conducting layer disposed on the respective other sides of said respective laminate layers;
- mounting, by means of an interconnecting arrangement, said at least two stripline layers substantially parallelly onto each other such that an overlap is formed between the adjacent, each other facing, conducting layers of said stripline layers, whereby said overlap includes a number of connectors, the dimension of the overlapping zone (L; L') in the plane of the interconnected stripline layers comprising approximately λ/4, λ being the wavelength corresponding to the mid-frequency of the RF waves handled by the arrangement.

19. A method according to claim 18,
**characterized in**
**that** it further comprises the step of:
- using said connectors as input/output ports, said input/output ports hence being located in different planes, on opposite sides of the stripline arrangement.

20. A method according to claim 18 or 19,
**characterized in**
**that** it comprises the step of:
- removing conducting material around the protruding portions of connectors acting as input/output ports;
- arranging housings to externally surround said as inputs/outputs acting connectors.

21. A method according to claim 20,
**characterized in**
**that** it comprises the step of:
- soldering said housings onto a respective ground plane provided on said conducting layers.

22. A method according to any one of claims 18-21,
**characterized in**
**that** it comprises the step of:
- bonding, by means of said interconnecting arrangement comprising a bonding layer, two conducting layers of said at least two stripline layers to each other such that, in the conducting layer overlapping zone, recesses or cut-outs are provided substantially around said perpendicularly to the extension plane of the transmission line arrangement extending connectors.

23. A method according to any one of claims 18-22,
**characterized in**
**that** the connectors comprise connector pins.

24. A method according to any one of claims 18-23,
**characterized in**
**that** it comprises the step of:
- connecting a number of modules by means of said connectors such that a vertical contact tile or brick-like connection assembly is formed.

## Patentansprüche

1. Streifenleitungsanordnung (10; 10'), die eine Zahl von Streifenleitungslagen (1₁, 2₁), die jeweils eine Laminatlage (1A, 1B) und leitende Lagen (2A, 2B; 2A, 2B, 3A, 3B) umfassen, die an jeder der Laminatlagen bereitgestellt werden, wobei die leitenden Lagen jeweils ein leitfähiges Muster umfassen, HF-Signal-Eingangs- bzw. -Ausgangsports umfasst, wobei wenigstens zwei der Streifenleitungslagen derart angeordnet sind, dass eine gegebene Überlappungszone (L; L') zwischen den jeweils gegenüberliegenden leitenden Lagen (2A, 2B) der Streifenleitungslagen bereitgestellt wird,
wobei eine Verbindungsanordnung (5) zum Verbinden der Streifenleitungslagen (1₁, 2₁), die eine Kontaktieranordnung (5) umfasst, zwischen benachbarten und einander gegenüberliegenden und überlappenden leitenden Lagen (2A, 2B) bereitgestellt wird, Steckverbinder (4A, 4B) im Wesentlichen senkrecht in Bezug auf eine Ausdehnungsebene der jeweiligen Streifenleitungslagen und die Laminatlagen (1A, 1B) kreuzend bereitgestellt werden, **dadurch gekennzeichnet, dass** sie dielektrische, ferroelektrische Lagen und leitende Lagen (2A, 2B, 3A, 3B) umfasst, wobei die Verbindungsanordnung in der Überlappungszone (L; L') einen Kontakt zwischen den benachbarten leitenden Lagen (2A, 2B) von benachbarten Streifenleitungslagen (1₁, 2₁) herstellt und dass die Abmessung der Überlappungszone (L; L') in der Ebene der verbundenen Streifenleitungslagen ungefähr λ/4 umfasst, wobei λ die Wellenlänge ist, die der Mittenfrequenz der durch die Anordnung gehandhabten HF-Wellen entspricht.

2. Streifenleitungsanordnung nach Anspruch 1, **dadurch gekennzeichnet,**
**dass** die leitenden Lagen (2A, 2B, 3A, 3B) ein Metall, z.B. Cu, Ag oder Au, umfassen.

3. Streifenleitungsanordnung nach einem der Ansprüche 1 oder 2, **dadurch gekennzeichnet,**
**dass** die Kontaktieranordnung (5) eine Kontaktierfolie umfasst.

4. Streifenleitungsanordnung nach einem der Ansprüche 1 bis 3, **dadurch gekennzeichnet,**
**dass** die Kontaktieranordnung Schrauben oder ähnliche mechanisch zu betätigende Verbindungsmittel umfasst.

5. Streifenleitungsanordnung nach Anspruch 3, **dadurch gekennzeichnet,**
**dass** die Kontaktierfolie (5) zwischen zwei leitenden Lagen (2A, 2B) derart angeordnet ist, dass sie Aussparungen (6A, 6B) oder Ähnliches angrenzend an die Steckverbinder (4A, 4B) oder in Verbindung mit denselben bereitstellt derart, dass die Aussparungen oder Ähnliches bereitgestellt werden, wo die Steckverbinder (4A, 4B) von einer leitenden Lage (2A, 2B) einer Streifenleitungslage vorspringen, um einen Kontakt mit der leitenden Lage (2B, 2A) der benachbarten Streifenleitungslage zu verhindern.

6. Streifenleitungsanordnung nach einem der Ansprüche 1 bis 5, **dadurch gekennzeichnet,**
**dass** die Steckverbinder (4A, 4B) Steckverbinderstifte umfassen, die in Durchgangslöchern in einer jeweiligen Streifenleitungslage aufgenommen werden.

7. Streifenleitungsanordnung nach einem der vorhergehenden Ansprüche, **dadurch gekennzeichnet,**
**dass** jede Laminatlage (1A, 1B) zwischen eine erste (2A, 2B) und eine zweite (3A, 3B) leitende Lage geschichtet ist.

8. Streifenleitungsanordnung nach Anspruch 7, **dadurch gekennzeichnet,**
**dass** die Eingangs- und/oder Ausgangsports durch einen oder mehrere der Steckverbinder (4A, 4B) gebildet werden.

9. Streifenleitungsanordnung nach Anspruch 8, **dadurch gekennzeichnet,**
**dass** die leitenden Lagen (3A, 3B) Aussparungen, Ausschnitte oder Ähnliches umfassen, was es ermöglicht, dass die Steckverbinder (4A, 4B) senkrecht in Bezug auf die Ausdehnungsebene der Streifenleitungslagen vorspringen, um die Eingangs- und/oder Ausgangsports zu bilden, ohne einen Kontakt mit den jeweiligen leitenden Lagen (3A, 3B) herzustellen, durch welche die Steckverbinder (4A, 4B) vorspringen.

10. Streifenleitungsanordnung nach Anspruch 9, **dadurch gekennzeichnet,**
**dass** die vorspringenden Abschnitte der Steckverbinder (4A, 4B), die Eingangs-/Ausgangsports bilden, in jeweiligen Gehäuses (7a, 7B) aufgenommen werden.

11. Streifenleitungsanordnung nach einem der vorhergehenden Ansprüche, **dadurch gekennzeichnet,**
**dass** mehrere Streifenleitungslagen im Wesentlichen senkrecht zu ihrer ebenen Ausdehnung verbunden sind, über Verbindungsanordnungen mit Modulen oder Elementen, die eine platten- oder ziegelartige Verbindungsbaugruppe bilden.

12. Streifenleitungsanordnung nach einem der Ansprüche 1 bis 11, **dadurch gekennzeichnet,**
**dass** sie eine Zweiwege-Streifenleitungsbaugruppe mit senkrecht zu der Ausdehnungsebene, z.B. vertikal, angeordneten Kontakten oder Steckverbindern umfasst derart, dass die Steckverbinder in unterschiedlichen Ebenen oder auf beiden oder gegenüberliegenden Seiten der Streifenleitungsbaugruppe angeordnet sind.

13. Streifenleitungsanordnung nach einem der vorhergehenden Ansprüche, **dadurch gekennzeichnet,**
**dass** die Steckverbinder GPO-, d.h., Gilbert-Aufsteck-, -Steckverbinder umfassen, jeweils mit einem Steckverbinderstift (4A, 4B) und einem Steckverbindergehäuse (7A, 7B), wobei der Steckverbinderstift in der Laminatlage oder einer Leiterplatte angeordnet ist und das Steckverbindergehäuse an eine Grundebene, die an der entsprechenden leitenden Lage angeordnet ist, gelötet oder Ähnliches ist.

14. Streifenleitungsanordnung nach einem der vorhergehenden Ansprüche, **dadurch gekennzeichnet,**
**dass** die relative Dielektrizitätskonstante (εᵣ) der Laminatlagen in Abhängigkeit von der Wellenlänge und der Anwendung der gehandhabten HF-/Mikrowellen gewählt ist und einen Wert von 2 bis 200 hat.

15. Streifenleitungsanordnung nach einem der vorhergehenden Ansprüche, **dadurch gekennzeichnet,**
**dass** sie ein Verteilungsnetz für eine Energieverteilung an mehrere Strahlungselemente in einem Antennensystem umfasst, wobei das Verteilungsnetz durch die leitenden Lagen (2A, 2B) in der Überlappungszone bereitgestellt wird.

16. Streifenleitungsanordnung nach einem der vorhergehenden Ansprüche, **dadurch gekennzeichnet,**
**dass** sie eine Streifenleitungsplatte mit zwei Laminatlagen (1A, 2B) umfasst.

17. Streifenleitungsanordnung nach einem der Ansprüche 1 bis 15, **dadurch gekennzeichnet,**
**dass** sie mehrere Streifenleitungslagen umfasst, wobei leitende Lagen auf beiden Seiten von jeweiligen Laminatlagen angeordnet sind, wobei wenigstens zwei benachbarte Streifenleitungslagen mit Hilfe von Kontaktlöchern verbunden sind und daher eine mehrlagige Struktur bilden.

18. Verfahren zum Herstellen einer Streifenleitungsanordnung, die eine Zahl von Streifenleitungslagen
umfasst, deren jede eine Laminatlage umfasst, die zwischen leitenden Lagen angeordnet ist,
**dadurch gekennzeichnet, dass** es die folgenden Schritte umfasst:
- Ätzen von leitfähigen Mustern in jeweiligen leitenden Lagen, die auf beiden Seiten einer dielektrischen oder ferroelektrischen Laminatlage angeordnet sind, für wenigstens zwei solcher Streifenleitungslagen,
- Anordnen von Steckverbindermitteln auf einer jeweiligen ersten leitenden Lage, die auf jeder der Laminatlagen angeordnet ist, derart, dass sich die Steckverbindermittel im Wesentlichen senkrecht zu der ebenen Ausdehnung derselben durch die Laminatlagen erstrecken derart, dass sie durch eine jeweilige zweite leitende Lage, die auf den jeweiligen anderen Seiten der jeweiligen Laminatlagen angeordnet ist, vorspringen,
- Anbringen, mit Hilfe einer Verbindungsanordnung, der wenigstens zwei Streifenleitungslagen im Wesentlichen parallel zueinander derart, dass eine Überlappung zwischen den benachbarten, einander gegenüberliegenden leitenden Lagen der Streifenleitungslagen geformt wird, wodurch die Überlappung eine Zahl von Steckverbindern einschließt, wobei die Abmessung der Überlappungszone (L; L') in der Ebene der verbundenen Streifenleitungslagen ungefähr λ/4 umfasst, wobei λ die Wellenlänge ist, die der Mittenfrequenz der durch die Anordnung gehandhabten HF-Wellen entspricht.

19. Verfahren nach Anspruch 18, **dadurch gekennzeichnet,**
**dass** es ferner den folgenden Schritt umfasst:
- Verwenden der Steckverbinder als Eingangs-/Ausgangsports, wobei die Eingangs-/Ausgangsports daher in unterschiedlichen Ebenen, auf gegenüberliegenden Seiten der Streifenleitungsanordnung, angeordnet sind.

20. Verfahren nach Anspruch 18 oder 19, **dadurch gekennzeichnet,**
**dass** es den folgenden Schritt umfasst:
- Entfernen von leitendem Material um die vorspringenden Abschnitte von Steckverbindern, die als Eingangs-/Ausgangsports dienen,
- Anordnen von Gehäusen, um die als Eingangs-/Ausgangsports dienenden Steckverbinder äußerlich zu umschließen.

21. Verfahren nach Anspruch 20, **dadurch gekennzeichnet,**
**dass** es den folgenden Schritt umfasst:
- Löten der Gehäuse an eine jeweilige Grundebene, die an den leitenden Lagen bereitgestellt wird.

22. Verfahren nach einem der Ansprüche 18 bis 21, **dadurch gekennzeichnet,**
**dass** es den folgenden Schritt umfasst:
- Kontaktieren von zwei leitenden Lagen der wenigstens zwei Streifenleitungslagen miteinander, mit Hilfe der Verbindungsanordnung, die eine Kontaktierlage umfasst, derart, dass in der Überlappungszone der leitenden Lagen im Wesentlichen um die sich senkrecht zu der Ausdehnungsebene der Übertragungsleitungsanordnung erstreckenden Steckverbinder Aussparungen oder Ausschnitte bereitgestellt werden.

23. Verfahren nach einem der Ansprüche 18 bis 22, **dadurch gekennzeichnet,**
**dass** die Steckverbinder Steckverbinderstifte umfassen.

24. Verfahren nach einem der Ansprüche 18 bis 23, **dadurch gekennzeichnet,**
**dass** es den folgenden Schritt umfasst:
- Verbinden einer Zahl von Modulen mit Hilfe der Steckverbinder derart, dass eine platten- oder ziegelartige Vertikalkontakt-Verbindungsbaugruppe gebildet wird.

## Revendications

1. Assemblage de ligne à microruban (10; 10'), comprenant plusieurs couches de ligne à microruban (1₁, 2₁) comprenant chacune une couche stratifiée (1A, 1B) et des couches conductrices (2A, 2B; 2A, 2B, 3A, 3B) agencées sur chacune desdites couches stratifiées, lesdites couches conductrices comprenant chacune un motif conducteur, des ports d'entrée et de sortie respectifs de signaux RF, au moins deux desdites couches de ligne à microruban étant agencées de sorte à établir une zone à chevauchement définie (L; L') entre les couches conductrices se faisant face (2A, 2B) desdites couches de ligne à microruban;
un assemblage d'interconnexion (5), pour interconnecter lesdites couches de la ligne à microruban (1₁, 2₁), comprenant un assemblage de liaison (5), étant agencé entre des couches conductrices adjacentes, sa faisant face et se chevauchant (2A, 2B), des connecteurs (4A, 4B) étant agencés de manière pratiquement perpendiculaires à un plan d'extension des couches de la ligne à microruban respectives et croisant lesdites couches stratifiées (1A, 1B), **caractérisé par** des couches diélectriques ferroélectriques et des couches conductrices (2A, 2B, 3A, 3B), ledit assemblage d'interconnexion établissant dans ladite zone à chevauchement (L; L') un contact entre les couches conductrices adjacentes (2A, 2B) des couches de la ligne à microruban adjacentes (1₁, 2₁), la dimension de la zone à chevauchement (L; L'), dans le plan des couches de la ligne à microruban interconnectées correspondant à environ γ/4, γ représentant la longueur d'onde correspondant à la fréquence centrale des ondes RF traitées par l'assemblage.

2. Assemblage de ligne à microruban selon la revendication 1, **caractérisé en ce que**
les couches conductrices (2A, 2B, 3A, 3B) comprennent un métal, par exemple du Cu, Ag ou Au.

3. Assemblage de ligne à microruban selon l'une quelconque des revendications 1 ou 2, **caractérisé en ce que**
l'assemblage de liaison (5) comprend un film de liaison.

4. Assemblage de ligne à microruban selon l'une quelconque des revendications 1 à 3, **caractérisé en ce que**
l'assemblage de liaison comprend des vis ou des moyens de connexion à actionnement mécanique ou similaires.

5. Assemblage de ligne à microruban selon la revendication 3, **caractérisé en ce que**
le film de liaison (5) entre deux couches conductrices (2A, 2B) est agencé de sorte à établir des évidements (6A, 6B) ou similaires près des connecteurs (4A, 4B) ou associés à ceux-ci, de sorte que lesdits évidements ou similaires sont au moins agencés au niveau des emplacements où les connecteurs (4A, 4B) débordent d'une couche conductrice (2A, 2B) d'une couche de ligne à microruban pour empêcher un contact avec la couche conductrice (2B, 2A) de la couche de ligne à microruban adjacente.

6. Assemblage de ligne à microruban selon l'une quelconque des revendications 1 à 5, **caractérisé en ce que**
les connecteurs (4A, 4B) comprennent des broches de connecteur reçues dans des trous traversants dans une couche de ligne à microruban respective.

7. Assemblage de ligne à microruban selon l'une quelconque des revendications précédentes,
**caractérisé en ce que**
chaque couche stratifiée (1A, 2A) est agencée en sandwich entre une première (2A, 2B) et une deuxième (3A, 3B) couche conductrice.

8. Assemblage de ligne à microruban selon la revendication 7, **caractérisé en ce que**
lesdits ports d'entrée et/ou de sortie sont formés par un ou plusieurs desdits connecteurs (4A, 4B).

9. Assemblage de ligne à microruban selon la revendication 7, **caractérisé en ce que**
les couches conductrices (3A, 3B) comprennent des évidements, des découpes ou similaires, permettant aux connecteurs (4A, 4B) de déborder perpendiculairement par rapport au plan d'extension des couches de ligne à microruban pour former lesdits ports d'entrée et/ou de sortie sans contacter les couches conductrices respectives (3A, 3B) à travers lesquelles débordent lesdits connecteurs (4A, 4B).

10. Assemblage de ligne à microruban selon la revendication 9, **caractérisé en ce que**
les parties en saillie des connecteurs (4A, 4B) formant des ports d'entrée/de sortie sont reçues dans des boîtiers respectifs (7A, 7B).

11. Assemblage de ligne à microruban selon l'une quelconque des revendications précédentes,
**caractérisé en ce que**
plusieurs couches de ligne à microruban sont interconnectées de manière pratiquement perpendiculaire à leur extension plane par des dispositifs de connexion avec des modules ou des éléments formant un assemblage de connexion du type carreau ou pavé.

12. Assemblage de ligne à microruban selon l'une quelconque des revendications 1 à 11, **caractérisé en ce qu'**il comprend un assemblage de ligne à microruban bidirectionnel, perpendiculaire au plan d'extension, par exemple des contacts ou des connecteurs à agencement vertical, de sorte que les connecteurs sont agencés dans des plans différents ou sur les deux côtés ou les côtés opposés de l'assemblage de ligne à microruban.

13. Assemblage de ligne à microruban selon l'une quelconque des revendications précédentes,
**caractérisé en ce que**
les connecteurs comprennent des connecteurs GPO (connecteurs Push On de Gilbert), comportant chacun une broche de connecteur (4A, 4B) et un boîtier de connecteur (7A, 7B), la broche de connecteur étant montée dans la couche stratifiée, ou une carte à circuit imprimé, le boîtier du connecteur étant soudé ou fixé d'une manière similaire sur un plan de masse agencé sur la couche conductrice correspondante.

14. Assemblage de ligne à microruban selon l'une quelconque des revendications précédentes,
**caractérisé en ce que**
la constante diélectrique (∈ᵣ) des couches stratifiées est sélectionnée sur la base de la longueur d'onde et de l'application d'ondes RF ou de micro-ondes traitées, et a une valeur comprise entre 2 et 200.

15. Assemblage de ligne à microruban selon l'une quelconque des revendications précédentes,
**caractérisé en ce qu'**il comprend un réseau de distribution pour assurer la distribution de l'énergie vers plusieurs éléments à rayonnement dans un système d'antenne, ledit réseau de distribution étant établi par les couches conductrices (2A, 2B) dans la zone à chevauchement.

16. Assemblage de ligne à microruban selon l'une quelconque des revendications précédentes,
**caractérisé en ce qu'**il comprend une plaque de ligne à microruban avec deux couches stratifiées (1A, 2B).

17. Assemblage de ligne à microruban selon l'une quelconque des revendications 1 à 15, **caractérisé en ce qu'**il comprend plusieurs couches de ligne à microruban avec des couches conductrices agencées sur les deux côtés de couches stratifiées respectives, au moins deux couches de ligne à microruban adjacentes étant interconnectées par l'intermédiaire de trous d'interconnexion, formant ainsi une structure multicouches.

18. Procédé de production d'un assemblage de ligne à microruban comprenant plusieurs couches de ligne à microruban, comprenant chacune une couche stratifiée agencée entre deux couches conductrices,
**caractérisé en ce qu'**il comprend les étapes ci-dessous:
- gravure de motifs conducteurs dans des couches conductrices respectives agencées des deux côtés d'une couche stratifiée diélectrique ou ferroélectrique pour au moins deux couches de ligne à microruban de ce type;
- agencement de moyens de connecteur sur une première couche conductrice respective agencée sur chacune desdites couches stratifiées, de sorte que lesdits moyens de connecteur s'étendent à travers lesdites couches stratifiées de manière pratiquement perpendiculaire à l'extension plane de celles-ci, débordant ainsi à travers une deuxième couche conductrice respective agencée sur les autres côtés respectifs desdites couches stratifiées respectives;
- montage, par l'intermédiaire d'un dispositif d'interconnexion, desdites au moins deux couches de ligne à microruban, de manière pratiquement parallèle l'une à l'autre, de sorte à établir un chevauchement entre les couches conductrices adjacentes se faisant face desdites couches de ligne à microruban, ledit chevauchement englobant ainsi plusieurs connecteurs, la dimension de la zone à chevauchement (L; L') dans le plan des couches de ligne à microruban interconnectées représentant environ γ/4, γ représentant la longueur d'onde correspondant à la fréquence centrale des ondes RF traitées par l'assemblage.

19. Procédé selon la revendication 18, **caractérisé en ce qu'**il comprend en outre l'étape ci-dessous:
utilisation desdits connecteurs comme ports d'entrée/de sortie, lesdits ports d'entrée/de sortie étant ainsi agencés dans différents plans, sur les côtés opposés de l'assemblage de ligne à microruban.

20. Procédé selon les revendications 18 ou 19, **caractérisé en ce qu'**il comrpend l'étape ci-dessous:
élimination de matériau conducteur autour des parties en saillie des connecteurs servant de ports d'entrée/de sortie;
agencement de boîtiers destinés à entourer l'extérieur desdits connecteurs servant de ports d'entrée/de sortie.

21. Procédé selon la revendication 20, **caractérisé en ce qu'**il comprend l'étape ci-dessous:
soudage desdits boîtiers sur un plan de masse respectif agencé sur lesdites couches conductrices.

22. Procédé selon l'une quelconque des revendications 18 à 21, **caractérisé en ce qu'**il comprend l'étape ci-dessous:
- liaison, par l'intermédiaire dudit assemblage d'interconnexion comprenant une couche de liaison, de deux couches conductrices desdites au moins deux couches de ligne à microruban, de sorte que dans la zone à chevauchement de la couche conductrice, des évidements ou des découpes sont formées pratiquement autour des connecteurs s'étendant perpendiculairement au plan d'extension de l'assemblage de ligne de transmission.

23. Procédé selon l'une quelconque des revendications 18 à 22, **caractérisé en ce que** les connecteurs comprennent des broches de connecteur.

24. Procédé selon l'une quelconque des revendications 18 à 23, **caractérisé en ce qu'**il comprend l'étape ci-dessous:
connexion de plusieurs modules par l'intermédiaire desdits connecteurs, de sorte à former un assemblage de connexion à pavé de contact vertical ou de type carreau.
